# FASCICULE DE BREVET EUROPEEN

(11) **EP 3 020 986 B1**
(45) Date de publication et mention de la délivrance du brevet: **28.02.2018**
(21) Numéro de dépôt: 15193543.4
(22) Date de dépôt: 06.11.2015
(51) Int. Cl.: F16B 41/00, G01R 11/24

(54) **BOÎTIER À FERMETURE SÉCURISÉE PAR CÂBLE SCELLÉ ET COMPTEUR ÉLECTRIQUE COMPORTANT UN TEL BOÎTIER**
GEHÄUSE MIT GESICHERTEM VERSCHLUSS MITHILFE EINES VERPLOMBTEN KABELS, UND STROMZÄHLER, DER MIT EINEM SOLCHEN GEHÄUSE AUSGESTATTET IST
HOUSING WITH SECURE CLOSURE BY SEALED CABLE AND ELECTRICITY METER COMPRISING SUCH A HOUSING

(30) Priorité: 13.11.2014 FR 1460970
(43) Date de publication de la demande: 18.05.2016
(73) Titulaire: SAGEMCOM ENERGY & TELECOM SAS, 92500 Rueil-Malmaison (FR)
(72) Inventeur: ROLLAND, Patrick, 92500 RUEIL MALMAISON (FR)
(74) Mandataire: Lavialle, Bruno François Stéphane

(56) Documents cités:
- EP-A1- 0 918 386
- CH-A- 403 917
- DE-U1- 8 707 084
- US-A1- 2013 088 214

## Description

La présente invention concerne la fermeture sécurisée d'un boîtier et plus particulièrement une fermeture sécurisée par un câble dont les extrémités sont scellées.

Un tel boîtier, tel que celui décrit dans le document DE 87 07 084 U, est par exemple utilisé pour les compteurs électriques reliant une installation électrique à un réseau de distribution d'électricité de manière à pouvoir mesurer le courant fourni par le réseau de distribution à l'installation électrique. Le boîtier comprend une première partie de boîtier qui est solidaire d'un socle pourvu de moyens de sa fixation sur un mur et qui contient un dispositif de mesure de courant et des moyens de raccordement de l'installation électrique au réseau de distribution via le dispositif de mesure de courant. Sur la première partie de boîtier est engagée une deuxième partie de boîtier formant couvercle pour condamner l'accès au dispositif de mesure et aux moyens de raccordement. Un fraudeur pourrait être tenté de démonter la deuxième partie de boîtier pour modifier le dispositif de mesure et/ou modifier le branchement de son installation de manière à soustraire au moins une partie du courant consommé au dispositif de mesure. Pour décourager les fraudeurs, il est prévu de pouvoir apposer un scellé sur le boîtier de telle manière qu'il soit nécessaire de briser le scellé pour pouvoir retirer la deuxième partie de boîtier. Lorsqu'un opérateur du gestionnaire du réseau de distribution intervient sur le compteur, il commence par vérifier l'intégrité du scellé. Si cet opérateur doit ôter la deuxième partie de boîtier pour accéder à l'intérieur du boîtier, il brise le scellé et posera un nouveau scellé une fois qu'il aura remis la deuxième partie de boîtier sur la première partie de boîtier.

La fixation de la deuxième partie de boîtier sur la première partie de boîtier est assurée par une vis engagée dans des logements ménagés en correspondance dans les parties de boîtier. Le logement de la deuxième partie de boîtier reçoit une tête de la vis et comporte deux orifices latéraux diamétralement opposés recevant des tronçons d'un câble de scellage traversant la tête de vis. Les extrémités du câble sont réunies par un sceau constitué de matière plastique ou de plomb qui doit être brisé pour permettre le retrait du câble. Le démontage de la deuxième partie de boîtier nécessite de faire pivoter la vis et la rotation de la vis n'est possible qu'après retrait ou rupture du câble de scellage.

Ainsi, l'absence de sceau ou un câble de scellage rompu permet de révéler qu'une tentative de fraude a eu lieu. Toutefois, la mise en place du câble de scellage n'est pas aisée. En particulier, lorsque l'extrémité du câble est trop souple ou n'est pas rectiligne, il arrive que cette extrémité vienne buter contre une portion de la deuxième partie de boîtier et/ou contre les bords du perçage de la tête de la vis recevant le câble de scellage. Les conditions d'éclairage et le positionnement du boîtier sur le mur ne permettent pas toujours de bien voir les orifices latéraux et l'entrée du perçage de la tête de vis, ce qui complique encore la mise en place du câble de scellage.

Un but de l'invention est de rendre plus facile l'apposition d'un scellé sur un boîtier.

A cet effet, on prévoit, selon l'invention, un boîtier comprenant les caractéristiques de la revendication 1 avec une première partie de boîtier sur laquelle est engagée une deuxième partie de boîtier de telle manière que les parties de boîtier aient des logements en correspondance pour recevoir une vis de fixation de la deuxième partie de boîtier à la première partie de boîtier. Le logement de la deuxième partie de boîtier reçoit une tête de la vis et comporte deux orifices latéraux diamétralement opposés pour le passage d'un câble de scellage reçu dans un alésage traversant la tête de la vis. Le logement de la deuxième partie de boîtier comprend deux portions de surface supérieure dans le prolongement des orifices au voisinage du logement et un pontet de retenue du câble dans l'orifice qui est adjacent à chaque orifice et qui s'étend au-dessus d'un espace séparant la portion de surface supérieure et l'orifice correspondants. La première partie de boîtier comprend deux saillies agencées pour chacune combler au moins partiellement un des espaces en ayant une surface supérieure affleurant la portion de surface supérieure correspondante de la deuxième partie de boîtier.

L'espace qui s'étend sous les pontets est généralement le résultat de contraintes techniques lors de la réalisation de la deuxième partie de boîtier par moulage. En effet, dans cet espace s'étend au moment du moulage une portion du moule servant à former la surface inférieure du pontet. Lors de l'installation du câble de scellage, les saillies empêchent l'extrémité de câble de rentrer dans l'espace qui sépare les orifices du fond des rainures. Ainsi, les saillies participent au guidage de l'extrémité de câble vers les orifices latéraux et la tête de la vis en limitant le risque que l'extrémité de câble bute contre un obstacle.

De préférence, en regard de chaque orifice s'étend une rainure de réception du câble de scellage traversant la tête de vis, chaque rainure ayant un fond format la portion de surface supérieure s'étendant dans le prolongement de chaque orifice.

Les rainures guident l'extrémité de câble vers les orifices et la tête de vis, facilitant la mise en place du câble.

L'invention a également pour objet un compteur électrique comportant un tel boîtier. La première partie de boîtier est solidaire d'un socle pourvu de moyens de sa fixation à un support et la deuxième partie de boîtier forme un couvercle condamnant un accès à un logement de la première partie de boîtier.

D'autres caractéristiques et avantages de l'invention ressortiront à la lecture de la description qui suit de modes de réalisation particuliers non limitatifs de l'invention.

Il sera fait référence aux dessins annexés, parmi lesquels :

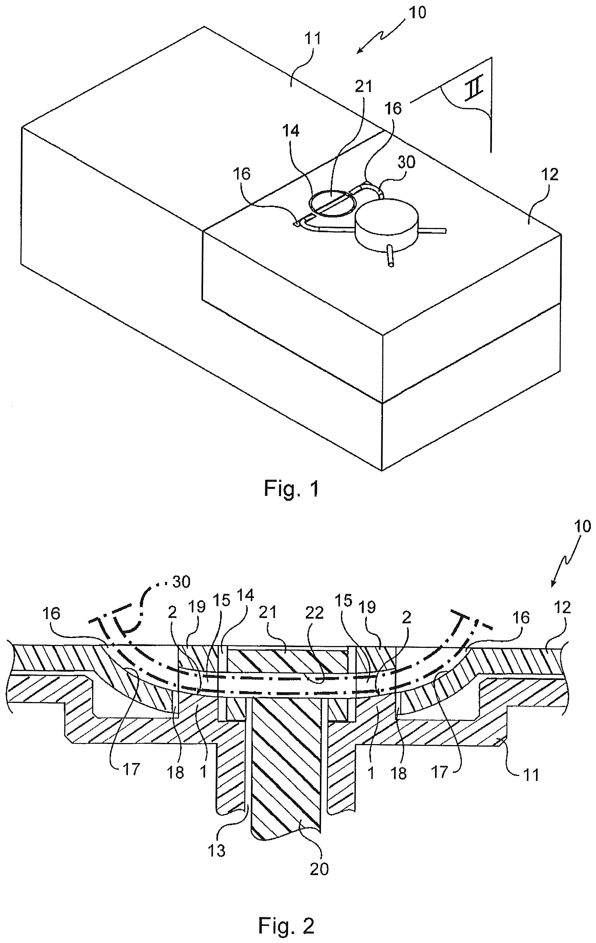

- la figure 1 est une vue en perspective d'un boîtier selon l'invention ;
- la figure 2 est une vue partielle de ce boîtier, en coupe selon le plan II de la figure 1.

L'invention est ici décrite en application à un compteur électrique. Toutefois, il va de soi que l'invention est applicable à tout autre type d'appareil.

En référence aux figures, le compteur électrique comporte un boîtier, généralement désigné en 10, comprenant une première partie de boîtier 11 sur laquelle est engagée une deuxième partie de boîtier 12. La première partie de boîtier 11 est solidaire d'un socle pourvu de moyens de sa fixation à un support tel qu'un mur et la deuxième partie de boîtier 12 forme un couvercle condamnant un accès à un logement 13 de la première partie de boîtier 11.

La deuxième partie de boîtier 12 est engagée sur la première partie de boîtier 11 de telle manière que les parties de boîtier 11, 12 aient des logements 13, 14 en correspondance pour recevoir une vis de fixation 20 de la deuxième partie de boîtier 12 à la première partie de boîtier 11.

La vis de fixation 20 est une vis de type quart de tour qui a une extrémité libre pourvue d'un ergot et qui est montée pour pivoter sur la deuxième partie de boîtier 12 en étant prisonnière de celle-ci. La vis de fixation 20 a une tête 21 pourvue d'un alésage 22 de réception d'un câble de scellage 30 traversant la tête 21 de la vis de fixation 20.

Le logement 13 comprend une ouverture autorisant le passage de l'extrémité libre de la vis de fixation 20 dans une première position angulaire et pour s'opposer à son passage dans une deuxième position angulaire (dans cette position l'ergot de l'extrémité libre de la vis de fixation 20 vient en butée contre un bord de l'ouverture).

Le logement 14 comprend une paroi tubulaire qui est dimensionnée pour recevoir à pivotement la tête 21 de la vis de fixation 20 et qui est pourvue de deux orifices latéraux 15 diamétralement opposés. En regard de chaque orifice latéral 15 s'étend une rainure 16 de réception du câble de scellage 30 traversant la tête 21. Chaque rainure 16 a un fond 17 formant une portion de surface supérieure de la deuxième partie de boîtier 12 s'étendant dans le prolongement de chaque orifice latéral 15 en étant séparé de l'orifice latéral 15 correspondant par un espace 18. Chaque rainure 16 a une profondeur qui décroît en s'éloignant du logement 14.

Chaque orifice latéral 15 est défini supérieurement par un pontet 19 s'étendant au-dessus de l'espace 18. Chacun des pontets 19 assure la retenue du câble 30 dans l'orifice 15 adjacent.

La première partie de boîtier 11 comprend deux saillies 1 agencées pour chacune combler un des espaces 18 en ayant une surface supérieure 2 affleurant le fond 17 de la rainure 16 adjacente à l'espace 18. Le fond 17 de chaque rainure est incliné vers le logement 14 la surface supérieure 2 de chaque saillie 1 s'étend dans le prolongement du fond 17 de la rainure 16 adjacente pour guider, lors de la mise en place du câble de scellage 30, une extrémité dudit câble vers l'alésage 22.

Bien entendu, l'invention n'est pas limitée aux modes de réalisation décrits mais englobe toute variante entrant dans le champ de l'invention telle que définie par les revendications.

En particulier, la forme du boîtier peut être différente de celle représentée aux figures.

Les saillies 2 peuvent ne combler que partiellement l'espace 18, ce qui permet de faciliter la mise en place du câble sans totalement éliminer le risque d'une butée du câble contre un obstacle.

La deuxième partie de boîtier peut être dépourvue de rainures.

## Revendications

1. Boîtier (10) comprenant une première partie de boîtier (11) sur laquelle est engagée une deuxième partie de boîtier (12) de telle manière que les parties de boîtier aient des logements (13, 14) en correspondance pour recevoir une vis de fixation (20) de la deuxième partie de boîtier à la première partie de boîtier, le logement de la deuxième partie de boîtier recevant une tête de la vis et comportant deux orifices latéraux (15) diamétralement opposés pour le passage d'un câble de scellage (30) reçu dans un alésage traversant la tête de la vis, **caractérisé en ce que** le logement de la deuxième partie de boîtier comprend deux portions de surface supérieure dans le prolongement des orifices au voisinage du logement et un pontet (19) de retenue du câble dans l'orifice qui est adjacent à chaque orifice et qui s'étend au-dessus d'un espace (18) séparant la portion de surface supérieure et l'orifice correspondants, et **en ce que** la première partie de boîtier comprend deux saillies (1) agencées pour chacune combler au moins partiellement un des espaces en ayant une surface supérieure affleurant la portion de surface supérieure correspondante de la deuxième partie de boîtier.

2. Boîtier selon la revendication 1, dans lequel en regard de chaque orifice (15) s'étend une rainure (16) de réception du câble de scellage traversant la tête de vis, chaque rainure ayant un fond (17) format la portion de surface supérieure s'étendant dans le prolongement de chaque orifice.

3. Boîtier selon la revendication 2, dans lequel chaque rainure (16) a une profondeur qui décroît en s'éloignant du logement.

4. Boîtier selon la revendication 3, dans lequel la surface supérieure de chaque saillie (1) s'étend dans le prolongement du fond (17) de la rainure (16) adjacente.

5. Compteur électrique comportant un boîtier selon l'une quelconque des revendications précédentes, la première partie de boîtier (11) étant solidaire d'un socle pourvu de moyens de sa fixation à un support et la deuxième partie de boîtier (12) formant un couvercle condamnant un accès à un logement de la première partie de boîtier.

## Patentansprüche

1. Gehäuse (10), das einen ersten Gehäuseteil (11) umfasst, auf dem ein zweiter Gehäuseteil (12) derart in Eingriff steht, dass die Gehäuseteile übereinstimmende Aufnahmen (13, 14) haben, um eine Befestigungsschraube (20) zur Befestigung des zweiten Gehäuseteils am ersten Gehäuseteil aufzunehmen, wobei die Aufnahme des zweiten Gehäuseteils einen Kopf der Schraube aufnimmt und zwei diametral entgegengesetzte seitliche Öffnungen (15) für den Durchtritt eines Abdichtungskabels (30) umfasst, das in einer Bohrung aufgenommen ist, die den Kopf der Schraube durchsetzt, **dadurch gekennzeichnet, dass** die Aufnahme des zweiten Gehäuseteils zwei Oberseitenabschnitte in der Verlängerung der Öffnungen nahe der Aufnahme und einen Steg (19) zum Halten des Kabels in der Öffnung umfasst, der an jede Öffnung angrenzt und sich über einem Zwischenraum (18) erstreckt, der den Oberseitenabschnitt und die Öffnung, die einander entsprechen, trennt, und dass der erste Gehäuseteil zwei Vorsprünge (1) umfasst, die so ausgebildet sind, dass sie jeweils zumindest teilweise einen der Zwischenräume auffüllen, indem sie eine Oberseite haben, die mit dem entsprechenden Oberseitenabschnitt des zweiten Gehäuseteils bündig abschließt.

2. Gehäuse nach Anspruch 1, bei dem sich gegenüber jeder Öffnung (15) eine Nut (16) zur Aufnahme des Abdichtungskabels erstreckt, das den Schraubenkopf durchsetzt, wobei jede Nut einen Boden (17) hat, der den Oberseitenabschnitt bildet, der sich in der Verlängerung jeder Öffnung erstreckt.

3. Gehäuse nach Anspruch 2, bei dem jede Nut (16) eine Tiefe hat, die mit Entfernung zur Aufnahme abnimmt.

4. Gehäuse nach Anspruch 3, bei dem sich die Oberseite jedes Vorsprungs (1) in der Verlängerung des Bodens (17) der angrenzenden Nut (16) erstreckt.

5. Elektrischer Zähler, umfassend ein Gehäuse nach einem der vorhergehenden Ansprüche, wobei der erste Gehäuseteil (11) fest mit einem Sockel verbunden ist, der mit Mitteln für seine Befestigung an einem Träger versehen ist, und der zweite Gehäuseteil (12) eine Abdeckung bildet, die einen Zugriff auf eine Aufnahme des ersten Gehäuseteils untersagt.

## Claims

1. A box (10) comprising a first box portion (11) having a second box portion (12) engaged thereon in such a manner that the box portions have matching housings (13, 14) for receiving a fastener screw (20) for fastening the second box portion to the first box portion, the housing of the second box portion receiving a head of the screw and includes two diametrically opposite side orifices (15) for passing a sealing wire (30) that is received in a bore passing through the head of the screw, the box being **characterized in that** the housing in the second box portion comprises two top surface fractions extending the orifices in the vicinity of the housing and a bridge (19) for retaining the cable in the orifice that is adjacent to each orifice and that extends over a gap (18) between the corresponding top surface fraction and orifice, and **in that** the first box portion has two projections (1), each arranged to occupy at least in part a respective one of the gaps, having a top surface that is flush with the corresponding top surface fraction of the second box portion.

2. A box according to claim 1, wherein a groove (16) for receiving the sealing wire that passes through the screw head extends in register with each orifice (15), each groove having a bottom (17) forming the top surface fraction lying in the extension of each orifice.

3. A box according to claim 2, wherein each groove (16) is of a depth that decreases going away from the housing.

4. A box according to claim 3, wherein the top surface of each projection (1) lies in the extension of the bottom (17) of the adjacent groove (16).

5. An electricity meter including a box according to any preceding claim, the first box portion (11) being secured to a base having means for fastening it to a support, and the second box portion (12) forming a cover preventing access to a housing of the first box portion.
